# EUROPEAN PATENT APPLICATION

(11) **EP 2 752 888 A1**
(43) Date of publication of application: **09.07.2014**
(21) Application number: 12827265.5
(22) Date of filing: 10.07.2012
(51) Int. Cl.: H01L 31/042

(54) **METHOD FOR PRODUCING SOLAR CELL MODULE AND SOLAR CELL MODULE**

(30) Priority: 31.08.2011 JP 2011189206; 31.08.2011 JP 2011189209; 20.09.2011 JP 2011204757
(71) Applicant: Sanyo Electric Co., Ltd., Osaka 570-8677 (JP)
(72) Inventor: KUDO, Yoshiyuki, Moriguchi City Osaka 570-8677 (JP); FUKUMOCHI, Shuji, Moriguchi City Osaka 570-8677 (JP)
(74) Representative: Glawe, Delfs, Moll
(86) International application number: PCT/JP2012/067543
(87) International publication number: WO 2013/031384

(57) **Abstract**

A manufacturing method suitable for solar modules is provided. A solar cell string 25 is inspected for the presence of any defective solar cell 20. When a defective solar cell 20a is found, the wiring members 30a, 30b bonding the defective solar cell 20a to the solar cells 20b, 20c adjacent to the defective solar cell 20a are disconnected, and the defective solar cell 20a is removed from the solar cell string 25. The wiring member pieces 33a, 33b are connected electrically to a new solar cell 20d, and the tip portions of the wiring member pieces 33a, 33b are connected electrically to the disconnected pieces 30a1, 30b1 connected electrically to the adjacent solar cells 20b, 20c. The wiring member pieces 33a, 33b are connected electrically while interposed between the disconnected pieces 30a1, 30b1 and the adjacent solar cells 20b, 20c.

## Description

### FIELD OF THE INVENTION

The present invention relates to a solar module and to a method for manufacturing a solar module.

### BACKGROUND

Interest in solar modules has increased in recent years as an energy source with a low environmental impact. Solar modules are usually provided with a solar cell string having a plurality of solar cells connected electrically by a wiring member.

Solar cells constituting a solar cell string are sometimes damaged when a solar module is manufactured. Patent Document 1 describes the use of damage-free solar cells in a solar cell string made possible by removing any damaged solar cell from the solar cell string and replacing the damaged solar cell with a new solar cell. In Patent Document 1, the solder bonding the solar cell to the wiring member is heated and melted to peel the wiring member from the solar cell.

### Prior Art Documents

### Patent Documents

Patent Document 1: Laid-Open Patent Publication No. 2011-134765

### SUMMARY

### Problem Solved by the Invention

However, when the wiring member is bonded to the solar cell using a resin adhesive, it is difficult to reliably remove the resin adhesive using heat. As a result, the method described in Patent Document 1 cannot be used when wiring members and solar cells are bonded to each other using a resin adhesive.

When a solar cell is replaced, the new solar cell is usually connected electrically using a wiring member having resin film and wiring arranged on the resin film (the "wiring member having resin film and wiring arranged on the resin film" is also referred to as a "printed circuit board" below). The printed circuit board is sometimes connected using solder.

However, methods using solder to electrically connect printed circuit boards have not been studied sufficiently. Therefore, a manufacturing method suitable for solar modules having printed circuit boards connected electrically using solder is desired.

It is an object of the present invention to provide a manufacturing method suitable for solar modules.

### Means of Solving the Problem

In the first method of the present invention for manufacturing a solar module, a solar cell string is created by electrically connecting a plurality of solar cells by bonding a wiring member to the solar cells using a resin adhesive. The solar cell string is inspected for the presence of any defective solar cell, and the wiring members bonding a defective solar cell to the solar cells adjacent to the defective solar cell are disconnected, and the defective solar cell removed from the solar cell string when a defective solar cell has been discovered. The tip portions of the wiring member pieces electrically connected to the new solar cell are electrically connected to the disconnected pieces of the wiring members connected electrically to adjacent solar cells while the wiring member pieces are interposed between the adjacent solar cells.

The first solar module of the present invention includes a plurality of solar cells, a wiring member, and a resin adhesive layer. The wiring member electrically connects the plurality of solar cells. The resin adhesive layer bonds the solar cells and the wiring member. The wiring member has a first wiring member piece and a second wiring member piece. The first wiring member piece is connected electrically to one solar cell of two adjacent solar cells. The second wiring piece is connected electrically to the other solar cell of the two adjacent solar cells. The second wiring member piece is also connected electrically to the first wiring member piece. The tip portion of the second wiring member piece is interposed between the first wiring member piece and the one solar cell of the two adjacent solar cells.

In the second method of the present invention for manufacturing a solar module, a plurality of solar cells is prepared having a first electrode and a second electrode on one main surface. A first wiring member is prepared having a first insulating film with flexible properties, and first wiring arranged on one main surface of the first insulating film. A solar cell string is created having a plurality of electrically connected solar cells by bonding a solar cell to a first wiring member using a resin adhesive while the first wiring side of the first wiring member is facing the solar cell to establish an electrical connection. The solar cell string is inspected for the presence of any defective solar cell, disconnecting the first wiring members bonding a defective solar cell to the solar cells adjacent to the defective solar cell, and the defective solar cell is removed from the solar cell string when a defective solar cell has been discovered. A new solar cell is electrically connected to a solar cell adjacent to the defective solar cell using a new wiring member, the disconnected piece of the first wiring is bent to form a first exposed portion in the disconnected piece having first wiring exposed on the one main surface side of the solar cell, and the new wiring member is connected electrically to a section of the first wiring positioned in the first exposed portion.

The third method of the present invention for manufacturing a solar module is a method related to a solar module provided with a wiring member having resin film and wiring arranged on the resin film and connected electrically using solder. The wiring member prepared for this manufacturing method is a wiring member having a section on which at least the resin film has not been provided. The wiring and a connected portion are connected electrically by melting solder using a heater, and the solder is interposed between the connected portion and the section of the wiring member on which at least the resin film has not been provided.

The second solar module of the present invention includes a solar cell, a wiring member, and solder. The wiring member has resin film and wiring arranged on the resin film. The solder electrically connects the solar cell and the wiring member either directly or indirectly. The resin film is not provided in at least some of the section of the wiring member electrically connected to the solar cell either directly or indirectly.

### Effect of the Invention

The present invention is able to provide a manufacturing method suitable for solar modules.

### BRIEF DESCRIPTION OF THE DRAWINGS

FIG. 1 is a simplified back view of a solar cell in the first embodiment.
FIG. 2 is a simplified side view of a solar cell string in the first embodiment.
FIG. 3 is a simplified plan view of section III in FIG. 2. In FIG. 3, the region in which a resin adhesive layer is provided is cross-hatched. The cross-hatched region is not shown in cross-section.
FIG. 4 is a simplified cross-sectional view from line IV-IV in FIG. 3.
FIG. 5 is a simplified back view of a wiring member in the first embodiment.
FIG. 6 is a simplified side view used to explain the solar module manufacturing process in the first embodiment.
FIG. 7 is a simplified side view used to explain the solar module manufacturing process in the first embodiment.
FIG. 8 is a simplified cross-sectional view used to explain the solar module manufacturing process in the first embodiment.
FIG. 9 is a simplified cross-sectional view of the solar module in the first embodiment.
FIG. 10 is a simplified side view used to explain the solar module manufacturing process in the second embodiment.
FIG. 11 is a simplified cross-sectional view used to explain the solar module manufacturing process in the second embodiment.
FIG. 12 is a simplified cross-sectional view of the solar module in the second embodiment.
FIG. 13 is a simplified back view of a solar cell in a first modified example of the second embodiment.
FIG. 14 is a simplified cross-sectional view of a portion of the solar module in a second modified example of the second embodiment.
FIG. 15 is a simplified plan view from arrow XV in FIG. 10.
FIG. 16 is a simplified partial cross-sectional view from line XVI-XVI in FIG. 10.
FIG. 17 is a simplified cross-sectional view of the solar module in the third embodiment.
FIG. 18 is a simplified cross-sectional view of a wiring member in a first modified example of the third embodiment.
FIG. 19 is a simplified plan view of a wiring member in a second modified example of the third embodiment.

### DETAILED DESCRIPTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### 1st Embodiment

### Manufacturing Method For Solar Module 1

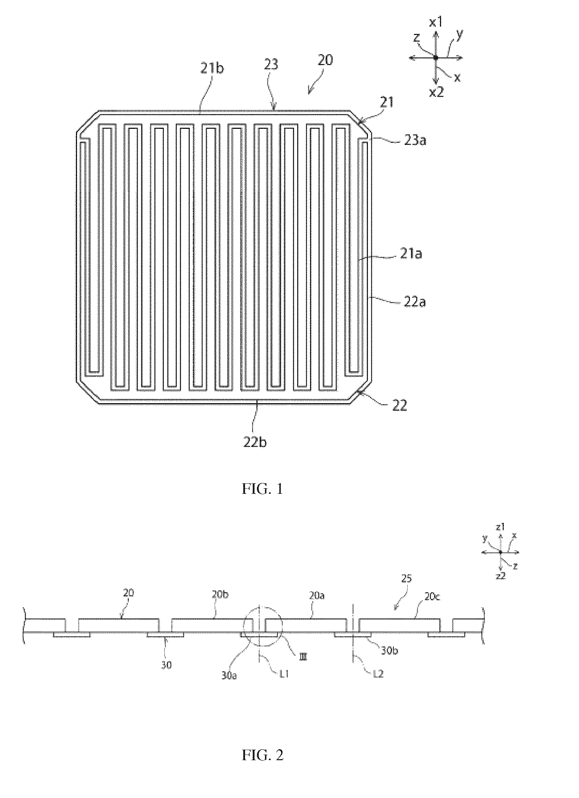

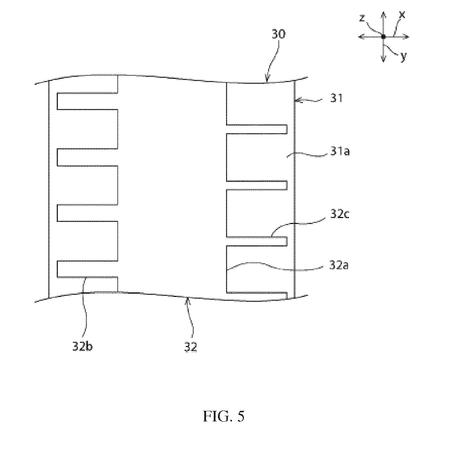

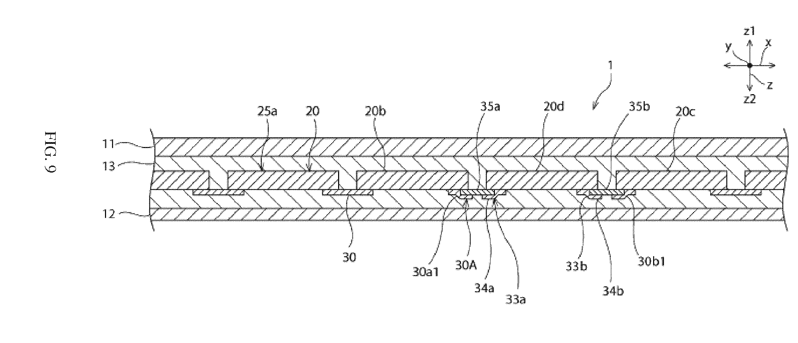

The following is an explanation of an example of a manufacturing method for the solar module 1 shown in FIG. 9 with reference to FIG. 1 through FIG. 9.

### Process For Preparing Solar Cells 20

First, several of the solar cells 20 shown in FIG. 1 are prepared. In the present embodiment, the solar cells 20 are back contact solar cells. However, the solar cells in the present invention are not limited to being back contact solar cells.

Each solar cell 20 has a photoelectric conversion unit 23. When exposed to light, the photoelectric conversion unit 23 generates carriers such as electrons and holes. The photoelectric conversion unit 23 has a light-receiving surface (not shown) and a back surface 23a. The back surface 23a of the photoelectric conversion unit 23 has both a p-type surface and an n-type surface.

The photoelectric conversion unit 23 may include a crystalline semiconductor substrate, and a p-type semiconductor layer and an n-type semiconductor layer provided on the same main surface of the substrate. In this case, the p-type surface is composed of the p-type semiconductor layer. The n-type surface is composed of the n-type semiconductor layer. A substantially intrinsic i-type semiconductor layer may be interposed between the substrate and both the p-type semiconductor layer and the n-type semiconductor layer at a thickness ranging from several Å to 250 Å which does not substantially contribute to the generation of electricity.

The photoelectric conversion unit 23 may be composed of a crystalline semiconductor substrate having both a p-type dopant diffusion region and an n-type dopant diffusion region provided on one main surface.

The crystalline semiconductor substrate can be composed of single-crystal silicon. The p-type semiconductor layer can be composed of p-type amorphous silicon. The n-type semiconductor layer can be composed of n-type amorphous silicon. The i-type semiconductor layer can be composed of i-type amorphous silicon.

A first electrode 21 and a second electrode 22 are arranged on the back surface 23a of the photoelectric conversion unit 23. Either the first electrode 21 or the second electrode 22 is a p-side electrode, and the other electrode is the n-side electrode. The p-side electrode is connected electrically to the p-type surface and collects holes. The n-side electrode is connected electrically to the n-type surface and collects electrons.

Both the first electrode 21 and the second electrode 22 have a comb shape. More specifically, both the first electrode 21 and the second electrode 22 have a plurality of finger portions 21a, 22a extending in the x-direction (one direction), and a busbar portion 21b, 22b connected electrically to the finger portions 21 a, 22a. The finger portions 21 a and the finger portions 22a are interdigitated in the y-direction (the other direction) which is orthogonal to the x-direction. Busbar portion 21b is arranged on the x1 side (the one side) of the finger portions 21a in the x-direction. Busbar portion 21b is provided from one end to the other in the y-direction on the x1 end of the back surface 23a. Busbar portion 22b is arranged on the x2 side (the other side) of the finger portions 22a in the x-direction. Busbar portion 22b is provided from one end to the other in the y-direction on the x2 end of the back surface 23a.

### Process For Creation of Solar Cell String 25

Next, the prepared solar cells 20 are connected electrically. More specifically, a solar cell string 25 with a plurality of solar cells 20 connected electrically via wiring members 30 is created by using a wiring member 30 to electrically connect the first electrode 21 of a solar cell 20 to the second electrode 22 of the adjacent solar cell 20 in the x-direction.

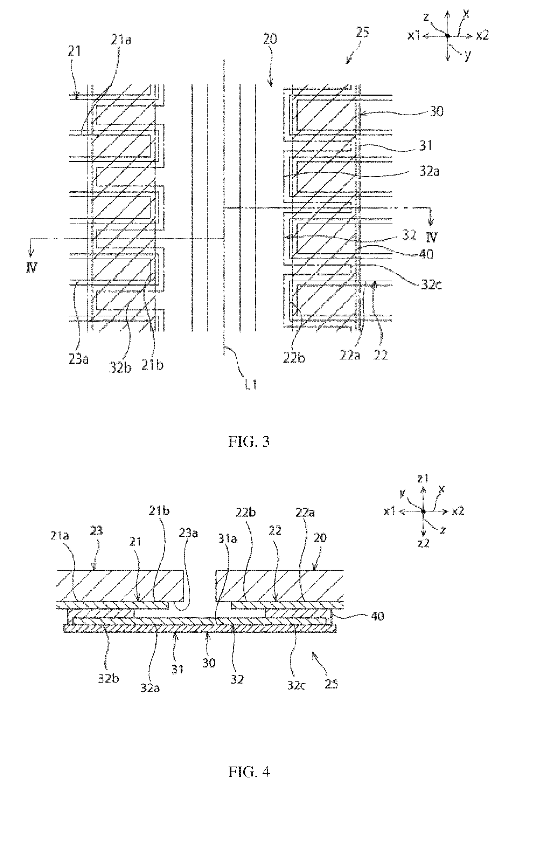

Each wiring member 30 has a slender shape extending in the y-direction. More specifically, the wiring member 30 has a rectangular shape extending longitudinally in the y-direction. As shown in FIG. 3 through FIG. 5, the wiring member 30 has an insulating substrate 31 and wiring 32. The insulating substrate 31 can be made of a resin or a ceramic. The insulating substrate 31 can be, for example, a flexible resin substrate. In the present invention, "substrate" may refer to a flexible sheet or film.

The wiring 32 is arranged on the surface 31a of the insulating substrate 31 on the solar cell 20 side. The wiring 32 is arranged on the solar cell 20 side, and the insulating substrate 31 is arranged on the side opposite the solar cell 20. The wiring 32 has conductive properties and is used to electrically connect adjacent solar cells 20 in the x-direction.

The wiring 32 has a wiring main body 32a and a plurality of first and second linear portions 32b, 32c. The wiring main body 32a has a slender shape. More specifically, the wiring main body 32a is rectangular. The central portion of the wiring main body 32a extending in the x-direction of the insulating substrate 31 extends from one end of the insulating substrate 31 in the y-direction, the y-direction being the direction in which the insulating substrate 31 extends.

Each of the first linear portions 32b extends from the wiring main body 32a in the x-direction towards the x1 end. The first linear portions 32b are interdigitated in the y-direction. Each of the first linear portions 32b is connected electrically to the wiring main body 32a.

The first linear portion 32b is arranged on the first electrode 21. The first linear portion 32b is connected electrically to the first electrode 21. More specifically, the first linear portion 32b is arranged on the finger portions 21a of the first electrode 21, and connected directly to the finger portions 21a electrically. In the present embodiment, the first linear portion 21b is not connected directly to the busbar portion 21b electrically. However, in the present invention, the first linear portion may be connected electrically to the busbar portion directly and not via the finger portions.

Each of the second linear portions 32c extends in the x-direction towards the x2 end from the wiring main body 32a. The second linear portions 32c are interdigitated in the y-direction. Each of the second linear portions 32c is connected electrically to the wiring main body 32a.

The second linear portions 32c are arranged on the second electrode 22. The second linear portions 32c are connected electrically to the second electrode 22. More specifically, the second linear portions 32c are arranged on the finger portions 22a of the second electrode 22, and electrically connected to the finger portions 22a directly. In the present embodiment, the second linear portions 32c are not connected directly to the busbar portion 22b electrically. However, in the present invention, the second linear portions may be connected electrically to the busbar portion directly and not via the finger portions.

The wiring member 30 and the solar cells 20 are bonded using a resin adhesive. The wiring member 30 and the solar cells 20 are bonded using a resin adhesive layer 40 containing a cured resin adhesive. The resin adhesive layer 40 may contain a conductive material in addition to the cured resin adhesive. Here, the wiring 32 of the wiring member 30 may be connected electrically to the first electrode 21 and the second electrode 22 via direct contact, or may be connected electrically via the conductive material instead of via direct contact. When the resin adhesive layer 40 does not contain a conductive material, the wiring 32 is preferably connected electrically to the first electrode 21 and the second electrode 22 via direct contact.

### Inspection Process

Next, the solar cell string 25 is inspected for the presence of any defective solar cell. Here, a defective solar cell means any solar cell that is scratched or damaged, or any solar cell whose semiconductor junctions have not been formed properly and which does not generate electricity when exposed to light. In other words, defective solar cells include physically defective solar cells and electrically defective solar cells.

There are no particular restrictions on the inspection process. Defective solar cells can be detected by performing a visual inspection using a microscope, an inspection using the photoluminescence (PL) method in which fluorescent light is detected when light is incident on the light-receiving surface, and an inspection using the electroluminescence (EL) method in which fluorescent light is detected when voltage is applied.

In the explanation of the present embodiment, only solar cell 20a in FIG. 2 is found to be defective among the solar cells 20 of the solar cell string 25.

### Replacement Process

In the present embodiment, because solar cell 20a was found to be defective in the inspection process, solar cell 20a has to be replaced in the replacement process. When no defective solar cells are found in the inspection process, the replacement process is not performed.

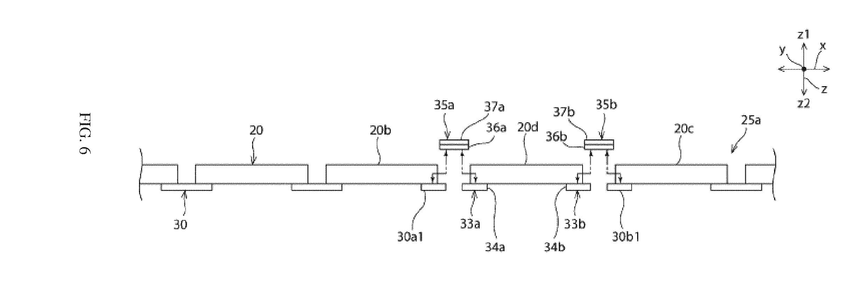

The solar cell 20a is first removed from the solar cell string 25. More specifically, the solar cell 20a found to be defective and the wiring members 30a, 30b bonded to the solar cells 20b, 20c adjacent to the solar cell 20a are cut. More specifically, the unbonded portion of wiring member 30a not bonded to the solar cells 20 is cut along cut line L1 between the portion bonded to solar cell 20a and the portion bonded to solar cell 20b. Also, the unbonded portion of wiring member 30b not bonded to the solar cells 20 is cut along cut line L2 between the portion bonded to solar cell 20a and the portion bonded to solar cell 20c. Afterwards, solar cell 20a is removed from the solar cell string 25. The disconnected piece 30a1 of wiring member 30a, and the disconnected piece 30b1 of wiring member 30b shown in FIG. 6 are bonded, respectively, to solar cell 20b and solar cell 20c.

Preferably, the disconnected piece 30a1 of wiring member 30a is cut so as to extend to the outside of the solar cell 20b, and the disconnected piece 30b1 of wiring member 30b is cut so as to extend to the outside of solar cell 20c. In other words, the cut lines L1, L2 are preferably closer to solar cell 20a than to solar cell 20b and solar cell 20c.

Next, a new solar cell 20d connected electrically to the first wiring member pieces 34a, 34b is prepared. Here, the new solar cell is a solar cell that was not included in the solar cell string inspected in the inspection process, and may be an unused solar cell or a solar cell that has been used before but is free of defects.

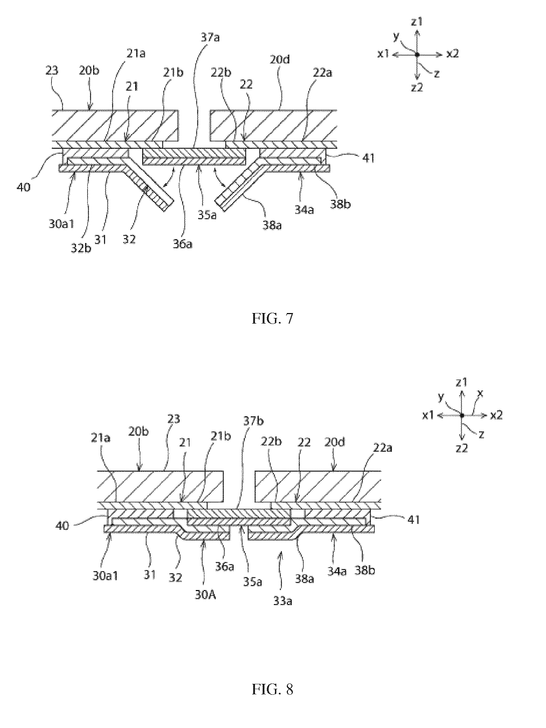

The first wiring member piece 34a has substantially the same configuration as the disconnected piece of the wiring member 30a bonded to the defective solar cell 20a. As shown in FIG. 7, the first wiring member piece 34a has an insulating substrate 38a, and wiring 38b connected electrically to the first electrode 21 and the second electrode 22. The first wiring member piece 34a is bonded to the solar cell 20d via a resin adhesive layer 41.

The first wiring member piece 34b has substantially the same configuration as the disconnected piece of the wiring member 30b bonded to the defective solar cell 20a. The first wiring member piece 34b has an insulating substrate 38a, and wiring 38b connected electrically to the first electrode 21 and the second electrode 22. The first wiring member piece 34b is bonded to the solar cell 20c via a resin adhesive layer 41.

Next, disconnected piece 30a1 and first wiring member piece 34a are connected electrically using the second wiring member piece 35a. Also, disconnected piece 30b1 and first wiring member piece 34b are connected electrically using the second wiring member piece 35b. More specifically, second wiring member piece 35a has an insulating substrate 37a and wiring 36a arranged on the insulating substrate 37a, and second wiring member piece 35b has an insulating substrate 37b and wiring 36b arranged on the insulating substrate 37b. Wiring 36a and wiring 38b are connected electrically to wiring 36b and wiring 32, respectively. The method used to electrically connect wiring 36a and wiring 38b to wiring 36b and wiring 32 can involve bonding them via direct contact using a resin adhesive, or joining them using solder.

In the present embodiment, the second wiring member 35a is arranged so the x1 end of the second wiring member 35a is positioned between solar cell 20b and disconnected piece 30a1, and the x2 end of the second wiring member 35a is positioned between solar cell 20d and wiring member piece 34b. Also, the second wiring member 35b is arranged so the x1 end of the second wiring member 35b is positioned between solar cell 20d and wiring member piece 34a, and the x2 end of the second wiring member 35b is positioned between solar cell 20c and disconnected piece 30b1. In other words, wiring member piece 33a and disconnected piece 30a1 are connected electrically with the x1 end of the wiring member piece 33a composed of second wiring member piece 35a and first wiring member piece 34a interposed between solar cell 20b and disconnected piece 30a1. Also, wiring member piece 33b and disconnected piece 30b1 are connected electrically with the x2 end of the wiring member piece 33b composed of second wiring member piece 35b and first wiring member piece 34b interposed between solar cell 20c and disconnected piece 30b1.

In this way, a new solar cell string 25a including a new solar cell 20d is created.

### Lamination Process

Next, as shown in FIG. 9, the solar cell string 25a is sealed between first and second protecting members 11, 12 using a bonding layer 13. More specifically, a resin sheet such as an EVA sheet constituting a portion of the bonding layer 13 is placed on the second protecting member 11. The solar cell string 25a is placed on top of this resin sheet, a resin sheet such as an EVA sheet constituting a portion of the bonding layer 13 is placed on top of this, and the first protecting member 12 is placed on top of this. These can then be laminated in a reduced-pressure atmosphere to complete the solar module 1.

### Configuration of Solar Module 1

The solar cell module 1 manufactured in this way has a solar cell string 25a bonded in a bonding layer 13 between a first protecting member 11 and a second protecting member 12. The solar cell string 25a has a plurality of solar cells 20. The solar cells 20 are connected electrically via wiring members 30, 30A. The wiring members 30, 30A and the solar cells 20 are bonded via resin adhesive layers 40, 41 containing cured resin adhesive.

Wiring member 30A is connected electrically to a first electrode 21 or a second electrode 22 of a solar cell 20, and is composed of the disconnected pieces 30a1, 30b1 connected electrically to the wiring member pieces 33a, 33b. The end of wiring member piece 33a is interposed between solar cell 20b and disconnected piece 30a1. The end of wiring member piece 33b is interposed between solar cell 20c and disconnected piece 30b1.

Wiring member piece 33a is composed of first wiring member piece 34a and second wiring member piece 35a. Wiring member piece 33b is composed of first wiring member 34b and second wiring member 35b. One end of the second wiring member piece 35a is interposed between solar cell 20b and disconnected piece 30a1, and the other end is interposed between solar cell 20d and the first wiring member piece 34a. One end of the second wiring member piece 35b is interposed between the solar cell 20c and disconnected piece 30b1, and the other end is interposed between solar cell 20d and the first wiring member piece 34b.

In the present embodiment, as explained above, the wiring member piece 33a is connected electrically to disconnected piece 30a1 while the tip portion of the wiring member piece 33a is interposed between solar cell 20b and disconnected piece 30a1 connected electrically to solar cell 20b. The wiring member piece 33b is connected electrically to disconnected piece 30b1 while the tip portion of the wiring member piece 33b is interposed between solar cell 20c and disconnected piece 30b1 connected electrically to solar cell 20c. Compared to a situation in which the tip portion of wiring member piece 33a is not interposed between solar cell 20b and disconnected piece 30a1 connected electrically to solar cell 20b, wiring member piece 33a and disconnected member 30a1 are bonded without increasing the distance between solar cell 20b and solar cell 20d in the x-direction. Similarly, compared to a situation in which the tip portion of wiring member piece 33b is not interposed between solar cell 20c and disconnected piece 30b1 connected electrically to solar cell 20c, wiring member piece 33b and disconnected member 30b1 are bonded without increasing the distance between solar cell 20c and solar cell 20d in the x-direction. As a result, the length of the electrically connected portion can be increased. This can make the electrical connection between wiring member piece 33a and disconnected piece 30a1, and between wiring member piece 33b and disconnected piece 30b1 more reliable, and can increase the bonding strength. In this way, a solar module 1 with superior output characteristics and superior reliability can be manufactured.

In the present invention, wiring member 30a is disconnected so that disconnected piece 30a1 extends to the outside of solar cell 20b. Also, wiring member 30b is disconnected so that disconnected piece 30b1 extends to the outside of solar cell 20c. In this way, the length of the disconnected pieces 30a1, 30b1 can be increased. This can make the electrical connection between wiring member piece 33a and disconnected piece 30a1, and between wiring member piece 33b and disconnected piece 30b1 more reliable, and can increase the bonding strength. In this way, a solar module 1 with even better reliability can be manufactured.

In the present embodiment, wiring member piece 33a is composed of first wiring member piece 34a and second wiring member piece 35a. Also, wiring member piece 33b is composed of first wiring member piece 34b and second wiring member piece 35b. The end portion of second wiring member piece 35a is interposed between first wiring member piece 34a and solar cell 20d, and the end of second wiring member piece 35b is interposed between first wiring member piece 34b and solar cell 20d. In this way, the first wiring member piece 34a and the second wiring member piece 35a can be bonded without increasing the distance between solar cell 20b and solar cell 20d in the x-direction, and the length of the electrically connected portion can be increased. Also, the first wiring member piece 34b and the second wiring member piece 35b can be bonded without increasing the distance between solar cell 20c and solar cell 20d in the x-direction, and the length of the electrically connected portion can be increased. In this way, the electrical connection between the first wiring member piece 34a and the second wiring member piece 35a, and between first wiring member piece 34b and the second wiring member piece 35b is more reliable, and the bonding strength can be increased.

The second wiring member piece 35a has wiring 36a and an insulating substrate 37a provided between solar cell 20b and solar cell 20d. The second wiring member piece 35b has wiring 36b and an insulating substrate 37b provided between solar cell 20c and solar cell 20d. This can prevent short circuits between the solar cells 20b to 20d due to the wiring 36a, 36b.

Each solar cell 20 is a back contact solar cell having a first electrode 21 and a second electrode 22 on the back surface 23a. As a result, the operations in which disconnected piece 30a1 is bonded to second wiring member piece 35a and disconnected piece 30b1 is bonded to second wiring member piece 35b, and the operations in which first wiring member piece 34a is bonded to second wiring member piece 35a and first wiring member piece 34b is bonded to second wiring member piece 35b can all be performed on the back surface side. The solar cell string 25 does not have to be turned over during the exchange process, which makes the exchange process easier to perform.

The present invention includes many embodiments not described herein. For example, in the explanation of the present invention, wiring member piece 33a is composed of a first wiring member piece 34a and a second wiring member piece 35a, and wiring member piece 33b is composed of a first wiring member piece 34b and a second wiring member piece 35b. However, the present invention is not restricted to this configuration. In the present invention, the wiring member pieces may be integrated.

The solar cells in the present invention do not have to be back contact solar cells. The solar cells may have a photoelectric conversion unit with a p-type surface on one main surface and an n-type surface on the other main surface.

The following is an explanation of other examples of preferred embodiments of the present invention. In the following explanation, any member having a function substantially identical to a member of the first embodiment is referenced by the same reference symbol and further explanation of the member is omitted. In the second embodiment, FIG. 1 through FIG. 5 are referenced in the same manner as the first embodiment. In the third embodiment, FIG. 1, FIG. 3, FIG. 4 and FIG. 10 are referenced in the same manner as the first and second embodiments.

### 2nd Embodiment

### Manufacturing Method For Solar Module 1

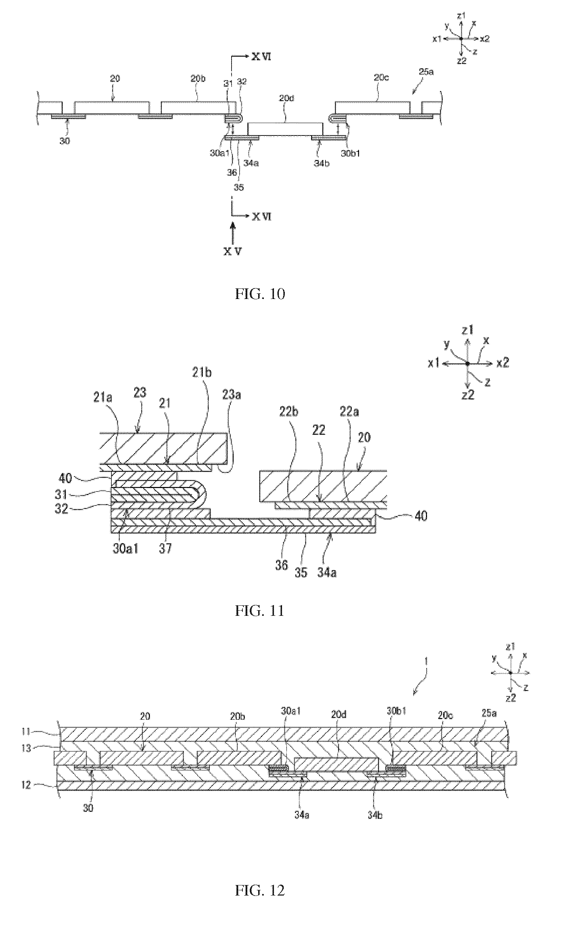

The following is an explanation of an example of a manufacturing method for the solar module 1 shown in FIG. 12.

### Process For Preparing Solar Cells 20

First, several of the solar cells 20 shown in FIG. 1 are prepared. In the present embodiment, the solar cells 20 are back contact solar cells.

### Process For Preparing Wiring Members 30

A plurality of solar cells 20 and at least one wiring member 30 are prepared. The wiring member 30 has a slender shape which extends in the y-direction. More specifically, the wiring member 30 has a rectangular shape and extends in the y-direction longitudinally.

As shown in FIG. 3 through FIG. 5, the wiring member 30 has a film-like insulating substrate 31 and wiring 32. The insulating substrate 31 has flexible properties. As a result, the insulating substrate 31 can bend. The insulating substrate 31 can be made of resin or a ceramic.

The wiring 32 is arranged on the main surface 31a of the insulating substrate 31 on the side with the solar cells 20.

There are no particular restrictions on the wiring member 30 has long as it has an insulating substrate 31 and wiring 32. There are no particular restrictions on the shapes of the insulating substrate 31 and the wiring 32. In the present embodiment, the wiring 32 has a wiring main body 32a and a plurality of first and second linear portions 32b, 32c. The wiring main body 32a has a slender shape. More specifically, the wiring main body 32a has a rectangular shape. The wiring main body 32a has a central portion on the insulating substrate 31 in the x-direction which extends from one y-axis end of the insulating substrate 31 to the other in the y-direction, or in the direction in which the insulating substrate 31 extends.

Each of the first linear portions 32b extends from the wiring main body 32a to the x1 end in the x-direction. The first linear portions 32b are interdigitated in the y-direction. Each of the first linear portions 32b is connected electrically to the wiring main body 32a.

Each of the second linear portions 32c extends from the wiring main body 32a to the x2 end in the x-direction. The second linear portions 32c are interdigitated in the y-direction. Each of the second linear portions 32c is connected electrically to the wiring main body 32a.

### Process For Creating a Solar Cell String

Next, a plurality of prepared solar cells 20 are connected electrically using a wiring member 30. More specifically, a solar cell string 25 in which a plurality of solar cells 20 have been connected electrically via a wiring member 30 is created by using a wiring member 30 to electrically connect the first electrode 21 of one of two adjacent solar cells 20 in the x-direction to a second electrode 22 of another of two adjacent solar cells 20. The solar cells 20 and the wiring members 30 are bonded via a resin adhesive layer 40 containing a cured resin adhesive.

The resin adhesive layer 40 may contain a cured resin adhesive, or may contain a conductive material in addition to the cured resin adhesive. Here, the wiring 32 of the wiring member 30 may be connected electrically to the first electrode 21 and the second electrode 22 via direct contact, or may be connected electrically via the conductive material instead of via direct contact. When the resin adhesive layer 40 does not contain a conductive material, the wiring member 32 is preferably connected electrically to the first electrode 21 and the second electrode 22 via direct contact.

In the solar cell production process, at least some of the first linear portions 32b are positioned above the first finger portions 21a of one solar cell 20, and the wiring member 30 is bonded using a resin adhesive to a region of the one solar cell 20 excluding the region in which the x2 end of the first electrode 21 is arranged in the x-direction (including at least the first busbar portion 21b), In this way, the first linear portions 32b of the wiring 32 of the wiring member 30 are connected electrically to the first finger portions 21a of the one solar cell 20.

Also, at least some of the second linear portions 32c are positioned above the second finger portions 22a of the other solar cell 20, and the wiring member 30 is bonded using a resin adhesive to a region of the other solar cell 20 excluding the region in which the x1 end of the second electrode 22 is arranged in the x-direction (including at least the second busbar portion 22b). In this way, the second linear portions 32c of the wiring 32 of the wiring member 30 are connected electrically to the second finger portions 22a of the other solar cell 20.

### Disconnecting Process

Next, the solar cell string 25 is inspected for the presence of any defective solar cell (inspection process). Here, a defective solar cell means any solar cell that is scratched or damaged, or any solar cell whose semiconductor junctions have not been formed properly and which does not generate electricity when exposed to light. In other words, defective solar cells include physically defective solar cells and electrically defective solar cells.

There are no particular restrictions on the inspection process. Defective solar cells can be detected by performing a visual inspection using a microscope, an inspection using the photoluminescence (PL) method in which fluorescent light is detected when light is incident on the light-receiving surface, and an inspection using the electroluminescence (EL) method in which fluorescent light is detected when voltage is applied.

In the explanation of the present embodiment, only solar cell 20a in FIG. 2 is found to be defective among the solar cells 20 of the solar cell string 25.

In the present embodiment, because solar cell 20a was found to be defective in the inspection process, solar cell 20a has to be replaced. When no defective solar cells are found in the inspection process, the replacement process is not performed.

When solar cell 20a is replaced, solar cell 20a is first removed from the solar cell string 25. More specifically, the solar cell 20a found to be defective is severed from the wiring members 30a, 30b bonded to the solar cells 20b, 20c adjacent to the solar cell 20a (cutting process).

More specifically, the unbonded portion of wiring member 30a not bonded to the solar cells 20 is cut along cut line L1 between the portion bonded to solar cell 20a and the portion bonded to solar cell 20b. Also, the unbonded portion of wiring member 30b not bonded to the solar cells 20 is cut along cut line L2 between the portion bonded to solar cell 20a and the portion bonded to solar cell 20c. Afterwards, solar cell 20a is removed from the solar cell string 25. As a result, the disconnected piece 30a1 of wiring member 30a, and the disconnected piece 30b1 of wiring member 30b remain bonded, respectively, to solar cell 20b and solar cell 20c via the resin adhesive layer 40. In the present embodiment, the disconnected pieces 30a1, 30b1 are preferably longer in the x-direction. Therefore, the wiring members 30a, 30b are preferably cut near the portion bonded to the defective solar cell 20a.

### Reconnecting Process

Next, a new solar cell 20d is prepared. Here, the new solar cell is a solar cell that was not included in the solar cell string inspected in the inspection process, and may be an unused solar cell or a solar cell that has been used before but is free of defects.

Next, an electrical connection is established between solar cell 20b and the new solar cell 20d using a new wiring member 34a, and an electrical connection is established between solar cell 20c and the new solar cell 20d using another new wiring member 34b. In this way, a new solar cell string 25a is created.

As in the case of the wiring member 30, these wiring members 34a and 34b have a sheet-like insulating substrate 35 and wiring 36. The wiring members 34a, 34b may have a configuration that is substantially the same as or different from the wiring member 30.

More specifically, disconnected piece 30a1 bonded to solar cell 20b that was adjacent to the defective solar cell 20a and disconnected piece 30b1 bonded to solar cell 20c that was adjacent to the defective solar cell are bent. In this way, an exposed section 37 is formed in each disconnected piece 30a1, 30b1 in which the wiring 32 is exposed on the side opposite the solar cells 20b, 20c. The wiring 36 of the exposed sections 37 and the wiring 36 of the new wiring members 34a, 34b are connected electrically. An insulating sheet (not shown) may be provided as a spacer in the region of the insulating substrate 35 interposed between the bent disconnected pieces 30a1, 30b1. The insulating sheet can be a resin sheet such as an EVA sheet.

### Lamination Process

Next, as shown in FIG. 12, the solar cell string 25a is sealed between first and second protecting members 12, 11 using a bonding layer 13. More specifically, a resin sheet such as an EVA sheet constituting a portion of the bonding layer 13 is placed on the second protecting member 11. The solar cell string 25a is placed on top of this resin sheet, a resin sheet such as an EVA sheet constituting a portion of the bonding layer 13 is placed on top of this, and the first protecting member 12 is placed on top of this. These can then be laminated in a reduced-pressure atmosphere to complete the solar module 1.

### Configuration of Solar Module 1

The solar module 1 manufactured in this manner has a solar cell string 25a sealed inside a bonding layer 13 between the first and second protecting members 12, 11. The solar cell string 25a has a plurality of solar cells 20. The solar cells 20 and wiring members 30, 34a, 34b are bonded via a resin adhesive layer 40 containing a cured resin adhesive. The electrical connection to the wiring members 34a, 34b and the disconnected pieces 30a1, 30b1 is direct via welding, or via a resin adhesive, solder or a conductive paste. The disconnected pieces 30a1, 30b1 have a bent structure.

In the present embodiment, as explained above, the electrical connections are established using exposed sections 37 formed by bending the disconnected pieces 30a1, 30b1. This can increase the contact area between the wiring 32 of the disconnected pieces 30a1, 30b1, and the wiring 36 of the new wiring members 34a, 34b. As a result, the contact resistance between the wiring 32 of the disconnected pieces 30a1, 30b1, and the wiring 36 of the new wiring members 34a, 34b can be reduced. In this way, a solar module 1 with better photoelectric conversion efficiency can be manufactured. The operation performed to establish electrical connections between wiring member 34a and disconnected piece 30a1 and between wiring member 34a and disconnected piece 30b1 can also be improved. This makes a solar module 1 easier to manufacture.

There are no particular restrictions on the method used to electrically connect the wiring 32 of the exposed sections 37 and the wiring 36 of the new wiring members 34a, 34b. For example, the wiring 32, 36 may be connected electrically using an anisotropically conductive resin adhesive containing a resin and a conductive material, the wiring 32, 36 may be connected electrically using solder or a conductive paste, or the wiring 32, 36 may be connected electrically using welding. The exposed sections 37 and the wiring members 34a, 34b may be bonded using a resin adhesive while the wiring 32, 36 is in direct contact. Preferably, the wiring 32, 36 may be connected electrically using solder or conductive paste, or the wiring 32, 36 may be connected electrically using welding. Compared to a situation in which the wiring 32, 36 is connected electrically using an anisotropically conductive resin adhesive, the contact resistance between the wiring 32, 36 can be reduced. In this way, a solar module 1 with better photoelectric conversion efficiency can be manufactured. Also, compared to a situation in which the wiring 32, 36 is connected electrically using an anisotropically conductive resin adhesive, pressure does not have to be applied to the wiring members 34a, 34b and to the disconnected pieces 30a1, 30b1 when the wiring 32, 36 is electrically connected. The operation performed to establish electrical connections between wiring member 34a and disconnected piece 30a1 and between wiring member 34a and disconnected piece 30a1 can also be improved. This makes a solar module 1 easier to manufacture.

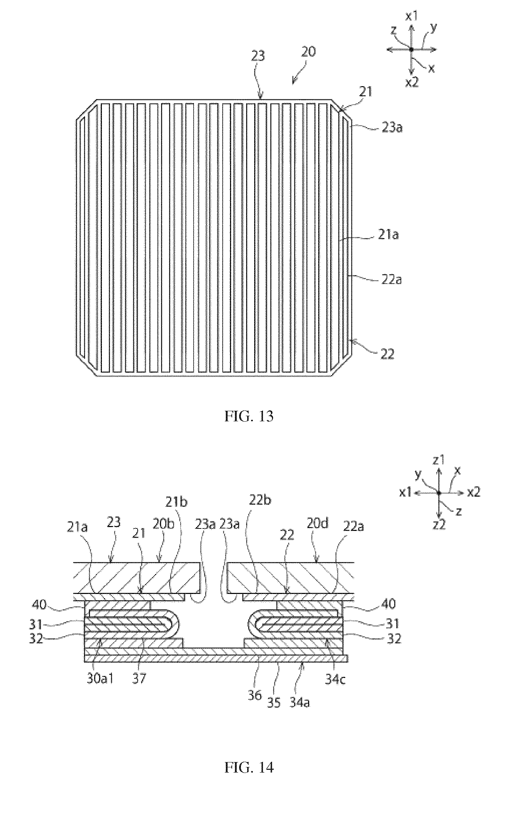

In the explanation of the present embodiment, each of the first electrodes 21 and second electrodes 22 has a busbar portion 21b, 22b. However, there are no restrictions in the present invention as long as the first and second electrodes are on one main surface. For example, as shown in FIG. 13, each of the first electrodes 21 and second electrodes 22 can be busbarless electrodes composed of finger portions 21 a, 22a.

As shown in FIG. 14, the solar cells 20b, 20c are bonded to the new solar cell 20d using new wiring members connected electrically to the new solar cell 20d, and may be configured to include a wiring member 34c having a bent structure substantially the same as that of disconnected piece 30a1 and a new wiring member 34a connected electrically to wiring member 34c and disconnected piece 30a1. In this way, the structure connecting solar cell 20b and solar cell 20d can be symmetrical from left to right. Also, solar cell 20b and solar cell 20d can be aligned in the z-direction so as to make a stepped structure less likely in the wiring member. This improves the reliability of the connection.

In the structure shown in FIG. 14, a metal plate or metal foil without insulating film may be provided instead of wiring member 34a.

A metal object without insulating film and without a bent structure may also be used instead of wiring member 34c. In this case, the thickness of the metal object is preferably substantially the same as the thickness of the disconnected piece 30a1 having a bent structure.

### 3rd Embodiment

### Manufacturing Method For Solar Module 1

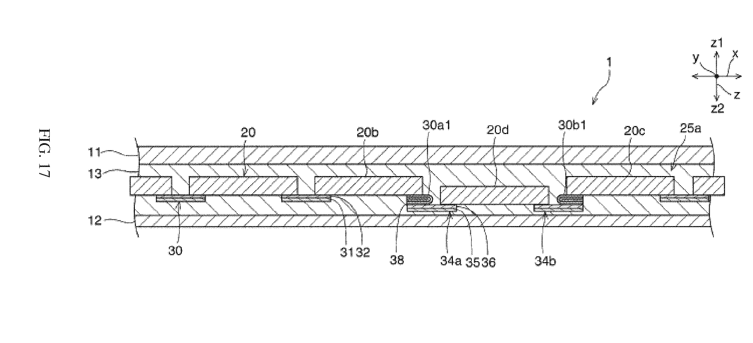

The following is an explanation of an example of a manufacturing method for the solar module 1 shown in FIG. 17.

First, solar cells 20 shown in FIG. 1 and the wiring member 30 shown in FIG. 3 and FIG. 4 are prepared. There are no particular restrictions on the type of solar cell 20 used. For example, the solar cells 20 may be solar cells using a crystalline semiconductor substrate, or thin-film solar cells.

The wiring member 30 is used to electrically connect the solar cells 20. The wiring members 30 may be composed of metal foil. However, in the present embodiment and as shown in FIG. 4, the wiring member is a printed circuit board having an insulating substrate 31 of resin film and wiring 32 arranged on the insulating substrate 31. The insulating substrate 31 is preferably flexible.

Next, as shown in FIG. 3, a solar cell string 25 having plurality of solar cells 20 connected electrically by wiring members 30 is created by electrically connecting the prepared solar cells 20 using wiring members 30. In the string manufacturing process, the solar cells 20 and wiring members 30 are secured using a resin adhesive. Therefore, as shown in FIG. 4, the solar cells 20 and the wiring members 30 are bonded via a resin adhesive layer 40 containing a cured resin adhesive. The resin adhesive layer 40 may include a conductive material and be anisotropically conductive.

Next, the solar cell string 25 is inspected for the presence of any defective solar cell (inspection process). Here, a defective solar cell means any solar cell that is scratched or damaged, or any solar cell whose semiconductor junctions have not been formed properly and which does not generate electricity when exposed to light. In other words, defective solar cells include physically defective solar cells and electrically defective solar cells.

There are no particular restrictions on the inspection process. Defective solar cells can be detected by performing a visual inspection using a microscope, an inspection using the photoluminescence (PL) method in which fluorescent light is detected when light is incident on the light-receiving surface, and an inspection using the electroluminescence (EL) method in which fluorescent light is detected when voltage is applied.

In the explanation of the present embodiment, only solar cell 20a in FIG. 3 is found to be defective among the solar cells 20 of the solar cell string 25.

In the present embodiment, because solar cell 20a was found to be defective in the inspection process, solar cell 20a has to be replaced in the replacement process. When no defective solar cells are found in the inspection process, the replacement process is not performed.

When the solar cell 20a is replaced, the solar cell 20a is first removed from the solar cell string 25. More specifically, the solar cell 20a found to be defective and the wiring members 30a, 30b bonded to the solar cells 20b, 20c adjacent to the solar cell 20a are cut along the cut lines L1, L2 (disconnection process).

More specifically, the unbonded portion of wiring member 30a not bonded to the solar cells 20 is cut along cut line L1 between the portion bonded to solar cell 20a and the portion bonded to solar cell 20b. Also, the unbonded portion of wiring member 30b not bonded to the solar cells 20 is cut along cut line L2 between the portion bonded to solar cell 20a and the portion bonded to solar cell 20c. Afterwards, solar cell 20a is removed from the solar cell string 25. The disconnected piece 30a1 of wiring member 30a, and the disconnected piece 30b1 of wiring member 30b are bonded, respectively, to solar cell 20b and solar cell 20c. In the present embodiment, the disconnected pieces 30a1, 30b1 are preferably longer in the x-direction. Therefore, the wiring members 30a, 30b are cut at least between solar cell 20a and solar cell 20b or solar cell 20c, preferably near the portion bonded to the defective solar cell 20a.

Next, as shown in FIG. 10, a new solar cell 20d is prepared. Here, the new solar cell is a solar cell that was not included in the solar cell string inspected in the inspection process, and may be an unused solar cell or a solar cell that has been used before but is free of defects.

Next, the new solar cell 20d is connected to solar cells 20b, 20c using the new wiring members 34a, 34b. In this way, a new solar cell string 25a is created.

As in the case of wiring member 30, wiring members 34a and 34b have an insulating substrate 35 of resin film, and wiring 36 arranged on the insulating substrate 35. The wiring members 34a, 34b may have a structure substantially the same as or different from wiring member 30.

More specifically, an electrical connection is established by joining, using solder, the disconnected piece 30a1 bonded to the solar cell 20b that was adjacent to the defective solar cell 20a, the wiring 32 of the disconnected piece 30b1 bonded to solar cell 20c, and the wiring 36 of the new wiring members 34a, 34b. Wiring member 34a and wiring member 34b have substantially the same configuration.

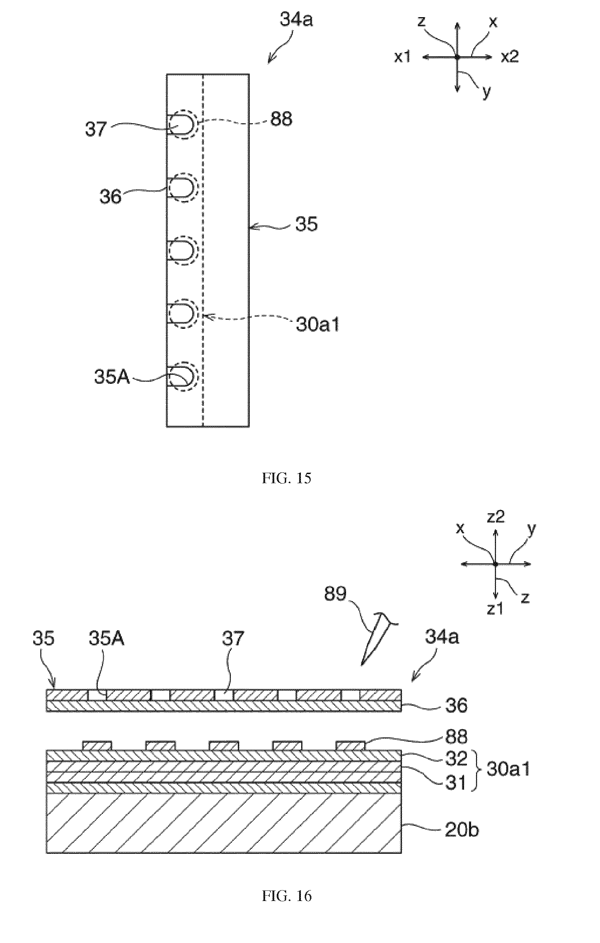

Here, as shown in FIG. 15 and FIG. 16, wiring members 34a and 34b have sections 37 in which at least an insulating substrate 35 is not provided. More specifically, a cut-out 35A is formed in the insulating substrate 35. In this way, a section 37 is provided which has wiring 36 but not an insulating substrate 35. Solder 88 is interposed between this section 37 and the disconnected pieces 30a1, 30b1 to be connected. In this situation, the solder 88 is heated by a heater 89 such as a soldering iron, and the melted solder joins and electrically connects the wiring 36 to the disconnected pieces 30a1, 30b1. In the present embodiment, the heater 89 applies pressure to the surface of the section 37 in which the wiring 36 is positioned on the side opposite the solder 88. In this way, the heat from the heater 89 is transmitted via the wiring 36 to the solder 88.

Next, as shown in FIG. 17, the solar cell string 25a is sealed between first and second protecting members 12, 11 using a bonding layer 13. More specifically, a resin sheet such as an EVA sheet constituting a portion of the bonding layer 13 is placed on the second protecting member 11. The solar cell string 25a is placed on top of this resin sheet, a resin sheet such as an EVA sheet constituting a portion of the bonding layer 13 is placed on top of this, and the first protecting member 12 is placed on top of this. These can then be laminated in a reduced-pressure atmosphere to complete the solar module 1.

The solar cell module 1 manufactured in this way has a solar cell string 25a bonded in a bonding layer 13 between a first protecting member 11 and a second protecting member 12. The solar cell string 25a has a plurality of solar cells 20. The solar cells 20 are connected electrically via wiring member 30, or wiring members 34a, 34b and disconnected pieces 30a1, 30b1. The wiring members 30, 34a, 34b and the solar cells 20 are bonded via resin adhesive layers 40 containing cured resin adhesive. The wiring members 34a, 34b and the disconnected pieces 30a1, 30b1 are connected electrically using solder 88. An insulating substrate 35 is not provided in at least some of the section 37 of the wiring members 34a, 34b connected electrically to the solar cells 20 either directly or indirectly.

However, when a printed circuit board having resin film and wiring arranged on the resin film is connected electrically using solder, pressure has to be applied using a heater such as a soldering iron from the resin film side to melt the solder. However, resin film has low thermal conductivity. It is therefore difficult to conduct a sufficient amount of heat to the solder when the heater is pressed against resin film. As a result, a good electrical connection is often not established with a printed circuit board.

In the present embodiment, solder 88 is interposed between a section 37 of the wiring members 34a, 34b in which the insulating substrate 35 is not provided and the disconnected pieces 30a1, 30b1 to be connected. In the present embodiment, the section 37 has wiring 36 with high thermal conductivity but not an insulating substrate 35. Therefore, the section 37 has high thermal conductivity. When the heater 89 is pressed against the section 37, the heat from the heater 89 is conducted efficiently to the solder 88. Because the solder 88 melts well, a good electrical connection can be established with the wiring members 34a, 34b. The thermal conductivity of the wiring 36 can be improved to establish an even better electrical connection with the wiring members 34a, 34b. Therefore, the wiring 36 preferably contains a metal such as Cu.

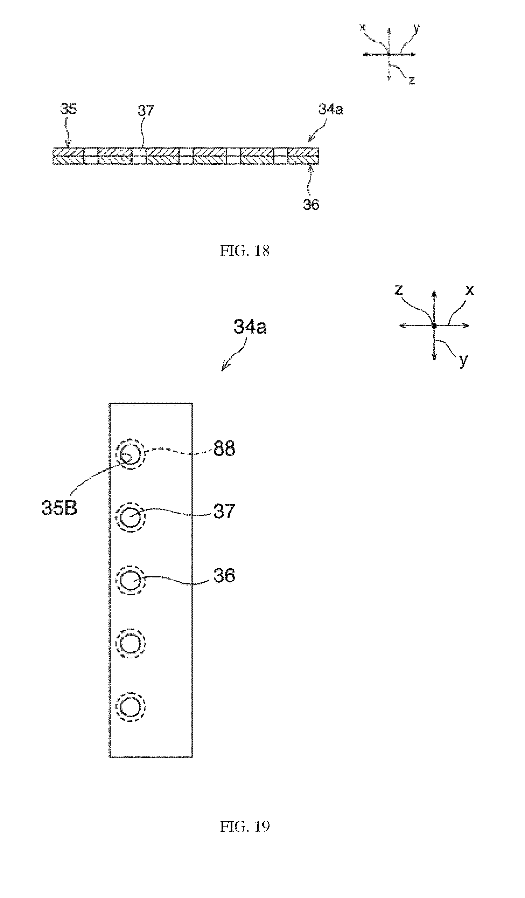

The present invention includes many embodiments not described herein. In the explanation of the present embodiment, wiring 36 was provided in a section 37 not including the insulating substrate 35. However, as shown in FIG. 18, the insulating substrate 35 and the wiring 36 do not have to be provided in this section 37. Instead, the section 37 may be composed of an opening or cut-out. In this case, the heater 89 is applied directly to the solder 88. Because the solder 88 can be heated more effectively, the electrical connection to the wiring members 34a, 34b can be improved.

In the explanation of the present embodiment, a cut-out 35A is provided in the insulating substrate 35. However, as long as heat from the heater 89 can be transmitted to the solder 88 via the wiring 36, an opening 35B may be formed in the insulating substrate 35 instead of a cut-out 35A, wiring member 34a may be staggered relative to disconnected piece 30a1, and wiring member 34b may be staggered relative to disconnected piece 30b1 to expose the wiring 36.

A wiring member having resin film and wiring on the resin film may be connected electrically to a wiring member of conductive foil using solder. Also, a wiring member having resin film and wiring on the resin film may be connected electrically to the electrodes of a solar cell using solder.

### Key to the Drawings

1: Solar module
20, 20a-20d: Solar cells
21: 1sit electrode
21a: 1 st finger portion
21b: 1sit busbar portion
22: 2nd electrode
22a: 2nd finger portion
22b: 2nd busbar portion
23: Photoelectric conversion unit
23a: Back surface
25, 25a: Solar cell strings
30, 30A, 30a, 30b, 34a, 34b: Wiring members
30a1, 30b1: Disconnected pieces
31, 35: Insulating substrates
32: Wiring
32b: 1st linear portion
32c: 2nd linear portion
33a, 33b: Wiring member pieces
35A: Cut-out
35B: Opening
36a, 36b: Wiring
40: Resin adhesive layer
41: Resin adhesive layer
L1, L2: Cut lines
88: Solder
89: Heater

## Claims

1. A method for manufacturing a solar module comprising the steps of:
creating a solar cell string by electrically connecting a plurality of solar cells by bonding a wiring member to the solar cells using a resin adhesive;
inspecting the solar cell string for the presence of any defective solar cell, disconnecting the wiring members bonding a defective solar cell to the solar cells adjacent to the defective solar cell, and removing the defective solar cell from the solar cell string when a defective solar cell has been discovered; and
electrically connecting wiring member pieces electrically connected to the new solar cell to the disconnected pieces of the wiring members connected electrically to adjacent solar cells while the tip portions of the wiring member pieces electrically connected to the new solar cell are interposed between the adjacent solar cells and the disconnected pieces of the wiring members.

2. The method for manufacturing a solar module according to claim 1, wherein the wiring members are disconnected so the disconnected pieces extend outward towards from the adjacent solar cells.

3. The method for manufacturing a solar module according to claim 1, wherein the wiring member pieces are produced by electrically connecting a first wiring member piece having been connected electrically to the new solar cell to a second wiring member piece having a tip portion interposed between the first wiring member piece and the new solar cell.

4. The method for manufacturing a solar module according to claim 1, wherein the wiring member piece has wiring and an insulating member for insulating between the wiring and the adjacent solar cell.

5. The method for manufacturing a solar module according to claim 1, wherein the solar cell is a solar cell having a p-side electrode and an n-side electrode on one main surface.

6. A solar module comprising:
a plurality of solar cells;
wiring members electrically connecting the plurality of solar cells; and
a resin adhesive layer bonding the solar cell and the wiring member;
the wiring member having a first wiring member piece connected electrically to one solar cell of two adjacent solar cells, and a second wiring piece connected electrically to the other solar cell of the two adjacent solar cells and connected electrically to the first wiring member piece; and
the tip portion of the second wiring member piece is interposed between the first wiring member piece and the one solar cell of the two adjacent solar cells.

7. A method for manufacturing a solar module comprising the steps of:
preparing a plurality of solar cells having a first electrode and a second electrode on one main surface;
preparing a first wiring member having a first insulating film having flexible properties, and first wiring arranged on one main surface of the first insulating film;
creating a solar cell string having a plurality of electrically connected solar cells by bonding the solar cell to the first wiring member using a resin adhesive while the first wiring side of the first wiring member is facing the solar cell to establish an electrical connection;
inspecting the solar cell string for the presence of any defective solar cell, disconnecting the first wiring members bonding a defective solar cell to the solar cells adjacent to the defective solar cell, and removing the defective solar cell from the solar cell string when a defective solar cell has been discovered; and
electrically connecting a new solar cell to the solar cells adjacent to the defective solar cell using new wiring members, the disconnected pieces of the first wiring members being bent to form first exposed portions in the disconnected pieces having first wirings exposed on the one main surface side of the solar cell, and the new wiring members being connected electrically to sections of the first wirings positioned in the first exposed portions.

8. The method for manufacturing a solar module according to claim 7, wherein the new solar cell is connected electrically to second wiring members constituting portions of the new wiring members having second insulating films with flexible properties and second wirings arranged on one main surface of the second insulating films;
the second wiring members being bent to form second exposed portions exposing the second wirings on the main surface side of the new solar cell; the sections of the first wirings positioned in the first exposed portions being electrically connected to section of the second wirings positioned in the second exposed portions using third wirings constituting the remaining portions of the new wiring members.

9. The method for manufacturing a solar module according to claim 7, wherein the sections of the first wirings positioned in the first exposed portions and the new wiring members are connected electrically using solder or conductive paste.

10. The method for manufacturing a solar module according to claim 7, wherein the sections of the first wirings positioned in the first exposed portions and the new wiring members are connected electrically using welding.

11. A method for manufacturing a solar module provided with a wiring member having resin film and wiring arranged on the resin film and connected electrically using solder, the method comprising the steps of:
preparing as the wiring member a wiring member having a section on which at least the resin film has not been provided; and
electrically connecting the wiring and a connected portion by melting solder using a heater, the solder being interposed between the connected portion and the section of the wiring member on which at least the resin film has not been provided.

12. The method for manufacturing a solar module according to claim 11, wherein wiring is not provided in at least some of the section in which at least resin film is not provided, an opening or cut-out is formed in at least some of the section in which at least resin film is not provided, and the solder is heated by bringing the heater into direct contact with the solder.

13. The method for manufacturing a solar module according to claim 11, wherein wiring is provided in at least some of the section in which at least resin film is not provided, and the solder is heated indirectly by bringing the heater into contact with the wiring.

14. The method for manufacturing a solar module according to claim 11, wherein the connected portion is another wiring member connected electrically to the solar cell.

15. A solar module comprising:
a solar cell;
a wiring member having resin film and wiring arranged on the resin film; and
solder electrically connecting the solar cell and the wiring member either directly or indirectly;
the resin film not being provided in at least some of the section of the wiring member electrically connected to the solar cell either directly or indirectly.
